# EUROPÄISCHE PATENTSCHRIFT

(11) **EP 0 501 200 B1**
(45) Veröffentlichungstag und Bekanntmachung des Hinweises auf die Patenterteilung: **20.08.1997**
(21) Anmeldenummer: 92102041.8
(22) Anmeldetag: 07.02.1992
(51) Int. Cl.: G01R 15/18, H01F 38/38, G01R 19/20, H01F 27/42

(54) **Elektrische Anlage mit Stromsensoren nach dem Kompen- sationsprinzip**
Electrical installation having compensation principle current sensors
Installation electrique ayant des capteurs de courant selon le principe de la compensation

(30) Priorität: 28.02.1991 DE 4106274
(43) Veröffentlichungstag der Anmeldung: 02.09.1992
(73) Patentinhaber: Vacuumschmelze GmbH, 63450 Hanau (DE)
(72) Erfinder: Lenhard, Friedrich, Dipl.-Ing., W-6450 Hanau 1 (DE)
(74) Vertreter: Fuchs, Franz-Josef, Dr.-Ing.

(56) Entgegenhaltungen:
- EP-A- 0 294 590
- EP-A- 0 356 248
- WO-A-90/10940
- ELECTRONIC COMPONENTS AND APPLICATIONS Bd. 3, Nr. 2, Februar 1981, EINDHOVEN NL Seiten 101 - 109 J.A.HOULDSWORTH 'Purpose-designed ferrite toroids for isolated current measurements in power electronic equipment'
- CONFERENCE RECORD OF THE 1989 IEEE INDUSTRY APPLICATIONS SOCIETY ANNUAL MEETING Nr. I, Oktober 1989, SAN DIEGO, CAL., US Seiten 343 - 347 T.SONODA ET AL. 'A Current Sensor of High Accuracy fit for Precise and Exact Motion Control'

## Beschreibung

Die Erfindung betrifft eine elektrische Anlage mit Stromsensoren nach dem Kompensationsprinzip, wobei in jedem der Stromsensoren das in einem Magnetkern von einer von dem zu messenden Strom durchflossenen Primärwicklung erzeugte Magnetfeld durch den Kompensationsstrom in einer Sekundärwicklung kompensiert wird, wobei zur Steuerung des Kompensationsstromes mindestens ein mit einer Indikatorwicklung versehener Meßkern aus weichmagnetischem Material zum Magnetkern so angeordnet ist, daß er einerseits von dessen Magnetfeld und andererseits von einem Wechselstrom in der Indikatorwicklung magnetisierbar ist, und daß in einer Auswerteschaltung zur Auswertung des Wechselstromes in der Indikatorwicklung dessen durch die vom Magnetkern verursachte Vormagnetisierung des Meßkerns bedingte Unsymmetrie zur Bestimmung des Kompensationsstromes ausgewertet wird.

Ein derartiger Stromsensor ist im Prinzip aus EP-294590 A2 bekannt. Bei diesem Stromsensor werden die Amplituden des in einer Indikatorwicklung fließenden Stromes getrennt für die positive und die negative Halbwelle verglichen. Je nach dem, wie der Meßkern - hier streifenförmiges Element genannt - durch den Magnetfluß im Magnetkern vormagnetisiert wird, erhält man am Ausgang einer Auswerteschaltung ein positives oder negatives Signal, das über einen Verstärker auf die Kompensationswicklung des Magnetkreises gegeben wird.

Der Erfindung liegt nun die Erkenntnis zugrunde, daß wegen der Auswertung der Unsymmetrie der positiven und negativen Halbwelle eines Wechselstromgenerators jede Unsymmetrie der vom Wechselstromgenerator erzeugten positiven und negativen Halbwellen einen Meßfehler verursachen kann.

Aufgabe der vorliegenden Erfindung ist es, bei Anwendung des bekannten Stromsensors für mehrphasige Systeme - insbesondere für Motorsteuerungen - zu erreichen, daß die Auswirkungen derartiger Fehler vermindert bzw. ausgeschaltet werden können.

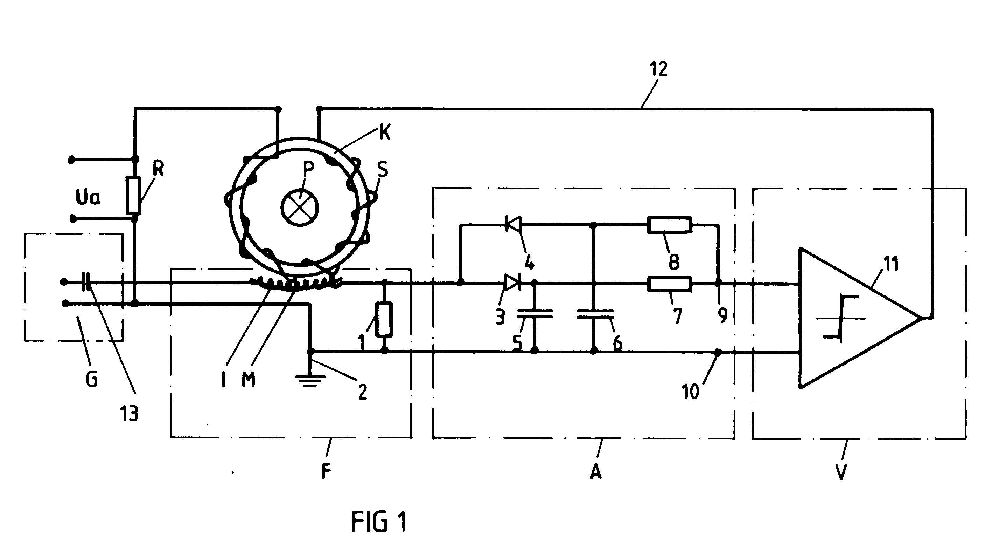

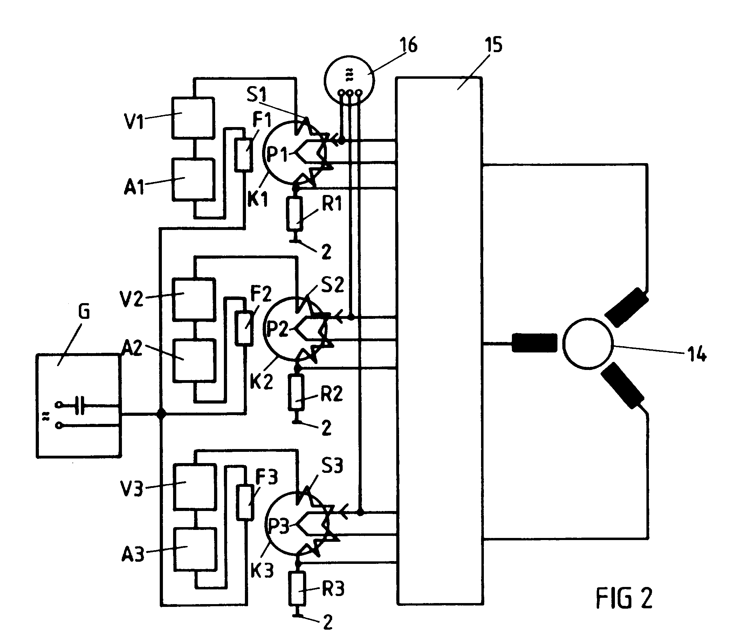

Figur 1 zeigt das Prinzipschaltbild entsprechend der bekannten Anordnung und in Figur 2 ist ein Blockschaltbild für den Einsatz des erfindungsgemäßen Stromsensors bei einer Motorsteuerung dargestellt.

In Figur 1 ist einem Wechselspannungsgenerator G ein Feldsensor F so nachgeschaltet, daß der vom Wechselspannungsgenerator G gelieferte Strom über eine Indikatorwicklung I und einen Widerstand 1 zur Erde 2 fließt. Hierdurch entsteht an den Klemmen des Widerstandes 1 eine Spannung, die dem Strom in der Indikatorwicklung I proportional ist. Die Indikatorwicklung I umschließt dabei einen Meßkern M, der außer von dem Strom in der Indikatorspule I auch von dem Magnetfluß in einem Magnetkern K beeinflußt wird.

Die an den Klemmen des Widerstands 1 entstehende Spannung wird nun einer Auswerteeinrichtung A zugeführt. Diese besteht aus zwei antiparallel geschalteten Dioden 3 und 4, die über Kondensatoren 5 und 6 mit Erde 2 verbunden sind. Die Dioden 3 und 4 liegen in Reihe zu Widerständen 7 und 8, die beide an eine Ausgangsklemme 9 der Auswerteschaltung angeschlossen sind. Die zweite Ausgangsklemme 10 der Auswerteschaltung ist wiederum mit Erde 2 verbunden.

Der Auswerteschaltung A ist nun eine Verstärkerschaltung V nachgeschaltet, die man auch als Regler mit Sollspannung nicht zwischen den Ausgangsklemmen 9 und 10 der Auswerteschaltung bezeichnen könnte. Die Verstärkerschaltung besteht im wesentlichen aus einem Verstärker 11, der schon bei sehr kleinen Werten der Eingansspannung seine maximale Ausgangsspannung abgibt - also einen sehr hohen Verstärkungsfaktor aufweist.

Der Verstärker 11 ist über eine Leitung 12 mit der Sekundärwicklung S des Magnetkerns K verbunden. Durch die Sekundärwicklung S fließt damit der Kompensationsstrom, der ein Maß für den Strom in der Primärwicklung P des Magnetkerns K darstellt. Der zweite Anschluß der Sekundärwicklung S ist über einen Meßwiderstand R wiederum mit Erde verbunden, so daß an dem Meßwidertand R eine Spannung abfällt, die dem Strom in der Sekundärwicklung und damit auch dem Strom in der Primärwicklung P proportional ist. Diese Spannung ist hier mit Ua bezeichnet.

Im vorgestellten Schaltungsbeispiel ist innerhalb des Wechselspannungsgenerators G ein Reihenkondensator 13 vorgesehen, so daß der Wechselspannungsgenerator G sowohl in der positiven als auch in der negativen Halbwelle jeweils die gleiche Stromzeitfläche aufweist - also keinen Gleichstromanteil enthält.

Wenn die Frequenz des Wechselspannungsgenerators G gegenüber der Frequenz in der Primärwicklung P sehr hoch ist, wird sich die Vormagnetisierung des Meßkerns während mehrerer Ummagnetisierungsperioden des Meßkerns M kaum ändern. Zur Erläuterung der Wirkungsweise kann also die durch den Meßstrom in der Primärwicklung P erzeugte Vormagnetisierung des Meßkerns M als konstant angenommen werden. Diese Vormagnetisierung ergibt sich durch die Differenz der von der Primärwicklung P und der Sekundärwicklung S erzeugten Flüsse im Magnetkern K und bewirkt, daß der Meßkern M entweder während der positiven oder der negativen Halbwelle des Stromes in der Indikatorwicklung weiter in die Sättigung ummagnetisiert wird.

Es wird also - auch abhängig von der Kurvenform der vom Wechselspannungsgenerator G gelieferten Spannung - die positive und negative Halbwelle des Stromes in der Indikatorwicklung I ( = Spannungsabfall am Widerstand 1) verschieden verformt. Die Halbwellen erhalten damit unter anderem unterschiedliche Maximalwerte, deren Differenz ein Maß für die Vormagnetisierung des Meßkernes darstellt. Anstelle einer bestimmten Wechselspannung könnte der Wechselspannungsgenerator G auch einen eingeprägten Strom liefern.

Diese unterschiedlichen Spannungsamplituden der Halbwellen werden nun in der Auswerteschaltung A ausgewertet. Der Kondensator 5 wird über die Diode 3 auf eine Spannung aufgeladen, die etwa der Amplitudenspannung der positiven Halbwelle entspricht, und über die Diode 4 wird der Kondensator 6 auf eine Spannung aufgeladen, die der negativen Amplitudenspannung des Spannungsabfalls am Widerstand 1 im Feldsensor F entspricht.

Durch die Widerstände 7 und 8 wird der Mittelwert beider Spannungen an den Kondensatoren 5 und 6 gebildet, der die Ausgangsspannung der Auswerteeinrichtung darstellt. Diese Ausgangsspannung verändert über den Verstärker 11 in der Verstärkerschaltung V den Kompensationsstrom in der Sekundärwicklung S und damit den Spannungsabfall am Meßwiderstand R so lange, bis die Vormagnetisierung des Meßkerns M verschwindet und damit die Ausgangsspannung der Auswerteschaltung A zu Null wird.

Aus dieser Wirkungsweise ist zu sehen, daß Unsymmetrien der positiven und negativen Halbwelle ausgenutzt werden, um den Magnetisierungszustand des Magnetkerns K zu erfassen. Anstelle der Auswertung der Stromamplitude - wie in dem vorliegenden Beispiel geschildert - können auch Unterschiede in der Größe oder der Strom- bzw. Spannungszeitfläche der unterschiedlichen Halbwellen des Stromes in der Indikatorwicklung I ausgenutzt werden, wie dies beispielsweise in der Anordnung nach DE-PS 3715789 der Fall ist, oder wie es auch in der DE-OS 3705450 beschrieben wird.

Eine vom Wechselspannungsgenerator G erzeugte Unsymmetrie in den positiven und negativen Halbwellen wird also mehr oder weniger das Meßergebnis beeinflussen, da die Auswerteschaltung A nicht unterscheiden kann, ob eine Unsymmetrie durch die Vormagnetisierung des Meßkerns M oder durch die Unterschiede in den Spannungsverläufen der vom Wechselspannungsgenerator G gelieferten Spannung herrührt.

Dies ist besonders nachteilig, wenn die Ströme in verschiedenen Phasen eines Verbrauchers auf den gleichen Wert geregelt werden sollen, da dann durch unterschiedliche Fehler in den Ausgangsspannungen verschiedener Wechselspannungsquellen für die einzelnen Stromsensoren unterschiedlich hohe Fehler in den verschiedenen Phasen gemessen werden.

Aus diesem Grunde wird erfindungsgemäß vorgeschlagen, verschiedene Stromsensoren, die in unterschiedliche Phasen eines mehrphasigen Systems eingeschaltet sind, extern an einen für alle gemeinsamen Wechselspannungsgenerator G anzuschließen.

Eine derartige Schaltung ist in Figur 2 dargestellt.

Figur 2 zeigt einen Synchronmotor 14 mit drei Wicklungen für ein dreiphasiges System, die alle an eine Motorsteuerung 15 angeschlossen sind. Die Primärwicklungen P1, P2 und P3 der Magnetkerne K1, K2 und K3 sind über die Motorsteuerung 15 an ein dreiphasiges Netz 16 angeschlossen, so daß in den Primärwicklungen P1, P2 und P3 die in den drei Wicklungen des Synchronmotors 14 fließenden Ströme erfaßt werden.

Für die Stromerzeugung aller drei Phasen des Netzes 16 ist nun ein einziger Wechselspannungsgenerator G vorgesehen, der entsprechend Figur 1 über je einen Feldsensor F1, F2 und F3, eine Auswerteschaltung A1, A2 und A3 sowie eine Verstärkerschaltung V1, V2 und V3 an die Sekundärwicklungen S1, S2 und S3 der Magnetkerne K1, K2 und K3 angeschlossen ist. Die Sekundärwicklungen S1, S2 und S3 sind ihrerseits über je einen Meßwiderstand R1, R2 und R3 mit Erde 2 verbunden. Die Abgriffe der Meßwiderstände R1, R2 und R3 sind an Reglereingänge der Motorsteuerung 15 angeschlossen und dienen dort als Istwerte der in den drei Wicklungen des Synchronmotors 14 fließenden Ströme.

Wenn beispielsweise der Synchronmotor 14 für eine Lageregelung einer Werkzeugmaschine oder dergleichen verwendet wird, so ist leicht einzusehen, daß unterschiedliche Ströme in den drei Phasen, die durch Meßfehler verursacht sein können, im Rythmus der Frequenz des Netzes 16 Schwingungen des Ankers des Synchronmotors und damit Schwingungen des in seiner Lage zu regelnden Objektes verursachen können.

Die Verwendung eines gemeinsamen Wechselspannungsgenerators für mehrere Stromsensoren in verschiedenen Phasen mit einem Fehler in der Ausgangsspannung bewirkt, daß dieser Fehler in der Spannung aller drei Stromsensoren in gleicher Weise vorhanden ist und sich damit auch gleichmäßig auf die Istwerte der von den drei Stromsensoren gelieferten Spannungen auswirkt. Selbst bei vorhandener Unsymmetrie in der Ausgangsspannung des Wechselspannungsgenerators G wird dies also nicht zu Schwingungen des Ankers des Synchronmotors 14 führen.

Im vorliegenden Fall sind drei Stromsensoren für drei Phasen des Synchronmotors 14 vorgesehen. Da die Summe der Ströme in den drei Phasen zu jedem Augenblick Null sein muß, kann mit Hilfe der Summe der drei Meßspannungen der Stromsensoren in den drei Phasen der vom Wechselspannungsgenerator G erzeugte Meßfehler ermittelt und zur Korrektur der Meßergebnisse der drei Phasen herangezogen werden, falls dies bei besonderen Anforderungen an die Stromregelung, beispielsweise zur genauen Steuerung des Drehmoments des Ankers in der Synchronmaschine 14, erforderlich ist.

Es ist darüberhinaus auch möglich, in einer elektrischen Anlage mit Stromsensoren, die beispielsweise an verschiedenen Stellen in einer Phase eingeschaltet sind, diese Stromsensoren an einen gemeinsamen Wechselspannungsgenerator anzuschließen. Auch hier wird vermieden, daß infolge von nicht vermeidbaren Unsymmetrien unterschiedliche Meßfehler auftreten.

## Patentansprüche

1. Elektrische Anlage mit Stromsensoren nach dem Kompensationsprinzip, wobei in jedem der Stromsensoren das in einem Magnetkern (K) von einer von dem zu messenden Strom durchflossenen Primärwicklung (P) erzeugte Magnetfeld durch den Kompensationsstrom in einer Sekundärwicklung (S) kompensiert wird, wobei zur Steuerung des Kompensationsstromes mindestens ein mit einer Indikatorwicklung (I) versehener Meßkern (M) aus weichmagnetischem Material zum Magnetkern (K) so angeordnet ist, daß er einerseits von dessen Magnetfeld und andererseits von einem Wechselstrom in der Indikatorwicklung (I) magnetisierbar ist, und daß in einer Auswerteschaltung (A) zur Auswertung des Wechselstromes in der katorwicklung (I) dessen durch die vom Magnetkern (K) verursachte Vormagnetisierung des Meßkerns (M) bedingte Unsymmetrie zur Bestimmung des Kompensationsstromes ausgewertet wird,
**dadurch gekennzeichnet,**
daß die Indikatorwicklungen (I) der Magnetkerne (K1, K2, K3) mehrerer Stromsensoren an einen gemeinsamen Wechselspannungsgenerator (G) angeschlossen sind.

2. Elektrische Anlage mit Stromsensoren nach dem Kompensationsprinzip nach Anspruch 1,
**dadurch gekennzeichnet,**
daß zur Erfassung von mehrphasigen Strömen in mindestens zwei Phasenleitern je ein Stromsensor eingeschaltet ist und daß die Magnetkerne (K1, K2, K3) der Stromsensoren zur Erzeugung des Wechselstromes extern an einen gemeinsamen Wechselspannungsgenerator (G) angeschlossen sind.

3. Elektrische Anlage mit Stromsensoren nach dem Kompensationsprinzip nach Anspruch 1,
**dadurch gekennzeichnet**,
daß für mehrphasige Verbraucher in jeder Phase des Verbrauchers ein Stromsensor vorgesehen ist und daß ein Summenbildner zur Abbildung der Summe der von den Stromsensoren abgebildeten Ströme in allen Phasen vorgesehen ist und daß der Ausgang des Summenbildners zur Kompensation des vom Wechselspannungsgenerator (G) erzeugten Meßfehlers dient.

## Claims

1. Electrical installation having current sensors based on the compensation principle with the magnetic field produced in a magnetic core (K) by a primary winding (P) through which the current to be measured flows being compensated in each of the current sensors by the compensation current in a secondary winding (S), at least one measuring core (M), provided with an indicator winding (I) and made of soft magnetic material, being, in order to control the compensation current, arranged with respect to the magnetic core (K) in such a way that it can be magnetized, on the one hand, by the magnetic field of the magnetic core and, on the other hand, by an alternating current in the indicator winding (I), and that, in an evaluation circuit (A) for evaluating the alternating current in the indicator winding (I), the assymmetry in this alternating current, due to the premagnetisation of the measuring core (M) caused by the magnetic core (K), is evaluated in order to determine the compensation current, characterized in that the indicator windings (I) of the magnetic cores (K1, K2, K3) of a plurality of current sensors are connected to a common AC voltage generator (G).

2. Electrical installation having current sensors based on the compensation principle, according to Claim 1, characterized in that, in order to measure multiphase currents, one current sensor is connected in each of at least two phase conductors, and in that the magnetic cores (K1, K2, K3) of the current sensors are, for producing the alternating current, externally connected to a common AC voltage generator (G).

3. Electrical installation having current sensors based on the compensation principle, according to Claim 1, characterized in that, for multiphase loads, a current sensor is provided in each phase of the load, and in that an adder is provided for acquiring the sum of the currents acquired by the current sensors in all the phases, and in that the output of the adder is used to compensate for the measurement error produced by the AC voltage generator (G).

## Revendications

1. Installation électrique ayant des capteurs de courant selon le principe de la compensation, dans laquelle, dans chacun des capteurs de courant, le champ magnétique créé dans un noyau magnétique (K) par un enroulement primaire (P) traversé par le courant à mesurer est compensé par le courant de compensation dans un enroulement secondaire (S), pour la commande du courant de compensation étant situé par rapport au noyau magnétique (K) au moins un noyau de mesure (M) fait d'un matériau magnétique doux et pourvu d'un enroulement indicateur (I), de manière à ce qu'il puisse être magnétisé d'une part par le champ magnétique de ce noyau magnétique et d'autre part par un courant alternatif dans l'enroulement indicateur (I), et à ce que, dans un circuit d'analyse (A) destiné à analyser le courant alternatif dans l'enroulement indicateur (I), la dissymétrie du courant alternatif due à la prémagnétisation du noyau de mesure (M) causée par le noyau magnétique (K) soit analysée afin de déterminer le courant de compensation, caractérisée en ce que les enroulements indicateurs (I) des noyaux magnétiques (K1, K2, K3) de plusieurs capteurs de courant sont reliés à un générateur de tension alternative (G) commun.

2. Installation électrique ayant des capteurs de courant selon le principe de la compensation selon la revendication 1, caractérisée en ce que, pour mesurer des courants polyphasés dans au moins deux fils de phase, un capteur de courant est intercalé à chaque fois, et en ce que les noyaux magnétiques (K1, K2, K3) des capteurs de courant sont reliés de manière externe à un générateur de tension alternative (G) commun pour produire le courant alternatif.

3. Installation électrique ayant des capteurs de courant selon le principe de la compensation selon la revendication 1, caractérisée en ce que, pour des consommateurs polyphasés, un capteur de courant est prévu dans chaque phase du consommateur, et en ce qu'un totalisateur est prévu dans toutes les phases pour représenter la somme des courants reproduits par les capteurs de courants, et en ce que la sortie du totalisateur sert à compenser l'erreur de mesure produite par le générateur de tension alternative (G).
